# FASCICULE DE BREVET EUROPEEN

(11) **EP 3 053 199 B1**
(45) Date de publication et mention de la délivrance du brevet: **12.09.2018**
(21) Numéro de dépôt: 14789321.8
(22) Date de dépôt: 30.09.2014
(51) Int. Cl.: H01L 33/00, H01L 33/18, H01L 33/62, H01L 33/38, H01L 33/08

(54) **PROCÉDÉ DE FABRICATION DE DISPOSITIFS OPTOELECTRONIQUES À DIODES ÉLECTROLUMINESCENTES**
VERFAHREN ZUR HERSTELLUNG EINER LICHTEMITTIERENDEN VORRICHTUNG
METHOD FOR PRODUCING A LIGHT EMITTING DEVICE

(30) Priorité: 30.09.2013 FR 1359413
(43) Date de publication de la demande: 10.08.2016
(60) Demande divisionnaire: 18178576.7
(73) Titulaire: Commissariat à l'Énergie Atomique et aux Énergies Alternatives, 75015 Paris (FR); Aledia, 38040 Grenoble (FR)
(72) Inventeur: BOUVIER, Christophe, F-38000 Grenoble (FR); POUGEOISE, Emilie, F-38000 Grenoble (FR); HUGON, Xavier, F-38470 Teche (FR); CAGLI, Carlo, F-38000 Grenoble (FR); DUPONT, Tiphaine, 38000 Grenoble (FR); GIBERT, Philippe, F-38960 St Etienne De Crossey (FR); AITMANI, Nacer, F-38120 Saint Egreve (FR)
(74) Mandataire: Cabinet Beaumont
(86) Numéro de dépôt international: PCT/FR2014/052472
(87) Numéro de publication internationale: WO 2015/044620

(56) Documents cités:
- WO-A1-03/012884
- WO-A1-2005/081319
- WO-A1-2013/080174
- US-A1- 2003 013 217
- US-A1- 2011 291 145
- US-A1- 2012 181 568
- US-A1- 2013 183 836

## Description

La présente demande de brevet revendique la priorité de la demande de brevet français FR13/59413.

### Domaine

La présente invention concerne de façon générale les procédés de fabrication de dispositifs optoélectroniques à base de matériaux semiconducteurs. La présente invention concerne plus particulièrement les procédés de fabrication de dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Les éléments tridimensionnels, notamment des microfils ou nanofils semiconducteurs, sont généralement formés sur un substrat qui est ensuite découpé pour délimiter des dispositifs optoélectroniques individuels. Chaque dispositif optoélectronique est alors disposé dans un boîtier, notamment pour protéger les éléments tridimensionnels. Le boîtier peut être fixé sur un support, par exemple un circuit imprimé.

Un inconvénient d'un tel procédé de fabrication de dispositifs optoélectroniques est que les étapes de protection des éléments tridimensionnels semiconducteurs doivent être réalisées séparément pour chaque dispositif optoélectronique. En outre, l'encombrement du boîtier peut être important par rapport à la zone active du dispositif optoélectronique comprenant les diodes électroluminescentes.

Document WO 2013/080174 A1 se rapporte à un procédé de fabrication de dispositifs optoélectroniques à base des éléments semiconducteurs filaires.

Documents WO 2005/081319 A1 et US 2012/181568 A1 se rapportent à des procédés de fabrication de dispositifs optoélectroniques contactés à travers le substrat.

### Résumé

Ainsi, un objet d'un mode de réalisation est de pallier au moins en partie les inconvénients des procédés de fabrication de dispositifs optoélectroniques à diodes électroluminescentes, notamment à microfils ou nanofils, décrits précédemment.

Un autre objet d'un mode de réalisation est de supprimer les boîtiers de protection individuels des dispositifs optoélectroniques à diodes électroluminescentes.

Un autre objet d'un mode de réalisation est que les dispositifs optoélectroniques à diodes électroluminescentes en matériau semiconducteur puissent être fabriqués à une échelle industrielle et à bas coût.

Ainsi, un mode de réalisation prévoit un procédé de fabrication de dispositifs optoélectroniques comprenant les étapes successives suivantes :
(a) prévoir un substrat comportant une première face ;
(b) former, sur la première face, des ensembles de diodes électroluminescentes comprenant des éléments semiconducteurs filaires, coniques ou tronconiques ;
(c) former, pour chaque ensemble de diodes électroluminescentes, une couche d'électrode recouvrant chaque diode électroluminescente dudit ensemble et une couche conductrice recouvrant la couche d'électrode autour des diodes électroluminescentes dudit ensemble ;
(d) recouvrir la totalité de la première face d'une couche encapsulant les diodes électroluminescentes ;
(e) réduire l'épaisseur du substrat, le substrat comprenant, après l'étape (e), une deuxième face opposée à la première face ;
(f) former un élément conducteur isolé électriquement du substrat et traversant le substrat depuis la deuxième face jusqu'à au moins la première face, l'élément conducteur étant en contact avec la couche conductrice ;
(g) former, sur la deuxième face, au moins un premier plot conducteur en contact avec le substrat ; et
(h) découper la structure obtenue pour séparer chaque ensemble de diodes électroluminescentes.

Selon un mode de réalisation, le procédé comprend, à l'étape (f), la formation, sur la deuxième face, au moins d'un deuxième plot conducteur en contact avec l'élément conducteur.

Selon un mode de réalisation, le procédé comprend la formation d'au moins un élément conducteur supplémentaire, isolé électriquement du substrat et traversant le substrat depuis la deuxième face jusqu'à au moins la première face, et en contact avec la base d'au moins l'une des diodes électroluminescentes.

Selon un mode de réalisation, la formation de l'élément conducteur comprend successivement, après l'étape (e), la gravure d'une ouverture dans le substrat depuis la deuxième face, la formation d'une couche isolante au moins sur les parois latérales de l'ouverture, et la formation d'une couche conductrice recouvrant la couche isolante, ou le remplissage de l'ouverture par un matériau conducteur.

Selon un mode de réalisation, la formation de l'élément conducteur comprend, avant l'étape (b), la gravure d'une ouverture dans le substrat depuis la première face sur une partie de l'épaisseur du substrat, l'ouverture étant ouverte sur la deuxième face après l'étape d'amincissement du substrat.

Selon un mode de réalisation, la couche d'électrode et la couche conductrice sont, en outre, formées dans l'ouverture.

Selon un mode de réalisation, le procédé comprend, avant l'étape (b), la formation d'une portion isolante au moins sur les parois latérales de l'ouverture et le remplissage de l'ouverture par un matériau conducteur.

Selon un mode de réalisation, à l'étape (e), le substrat est retiré en totalité.

Selon un mode de réalisation, le procédé comprend, en outre, pour chaque ensemble de diodes électroluminescentes, le dépôt d'au moins une couche conductrice au contact avec les bases des diodes dudit ensemble.

Selon un mode de réalisation, le procédé comprend, avant l'étape (e), une étape de fixation d'un support à la couche encapsulant les diodes électroluminescentes.

Selon un mode de réalisation, la couche encapsulant les diodes électroluminescentes comprend des luminophores entre les diodes électroluminescentes.

Selon un mode de réalisation, le procédé comprend une étape de formation d'une couche de luminophores recouvrant la couche encapsulant les diodes électroluminescentes ou recouvrant le support.

Selon un mode de réalisation, le procédé comprend une étape de formation d'une couche, entre la couche encapsulant les diodes électroluminescentes et la couche de luminophores, adaptée à transmettre les rayons lumineux émis par les diodes électroluminescentes et à réfléchir les rayons lumineux émis par les luminophores.

Selon un mode de réalisation, le procédé comprend une étape de formation de réflecteurs autour des diodes électroluminescentes entre le substrat et la couche encapsulant les diodes électroluminescentes et dont la hauteur est supérieure à 50 % de la hauteur des diodes électroluminescentes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de dessus, partielle et schématique, d'un exemple d'une plaque d'un substrat semiconducteur sur laquelle sont réalisés plusieurs dispositifs optoélectroniques à microfils ou nanofils ;
les figures 2A à 2F sont des coupes, partielles et schématiques, de structures obtenues à des étapes successives d'un mode de réalisation d'un procédé de fabrication de dispositifs optoélectroniques à microfils ou nanofils ;
les figures 3A et 3B sont des coupes, partielles et schématiques, de structures obtenues à des étapes successives d'un autre mode de réalisation d'un procédé de fabrication de dispositifs optoélectroniques à microfils ou nanofils ;
les figures 4 et 5 sont des coupes, partielles et schématiques, de structures obtenues par d'autres modes de réalisation de procédés de fabrication de dispositifs optoélectroniques à microfils ou nanofils ;
les figures 6A à 6C sont des coupes, partielles et schématiques, de structures obtenues à des étapes successives d'un autre mode de réalisation d'un procédé de fabrication de dispositifs optoélectroniques à microfils ou nanofils ;
les figures 7A et 7B sont des coupes, partielles et schématiques, de structures obtenues à des étapes successives d'un autre mode de réalisation d'un procédé de fabrication de dispositifs optoélectroniques à microfils ou nanofils ;
les figures 8 à 10 sont des coupes, partielles et schématiques, de structures obtenues par d'autres modes de réalisation de procédés de fabrication de dispositifs optoélectroniques à microfils ou nanofils ;
les figures 11A à 11D sont des coupes, partielles et schématiques, de structures obtenues à des étapes successives d'un autre mode de réalisation d'un procédé de fabrication de dispositifs optoélectroniques à microfils ou nanofils ;
les figures 12A à 12E sont des coupes, partielles et schématiques, de structures obtenues à des étapes successives d'un autre mode de réalisation d'un procédé de fabrication de dispositifs optoélectroniques à microfils ou nanofils ;
la figure 13 est une coupe, partielle et schématique, d'un mode de réalisation d'un dispositif optoélectronique à microfils ou nanofils formé sur une plaque d'un substrat avant la découpe du substrat ;
la figure 14 est une vue de dessus, partielle et schématique, du dispositif optoélectronique de la figure 13 ; et
les figures 15 à 27 sont des coupes, partielles et schématiques, de modes de réalisation de dispositifs optoélectroniques à microfils ou nanofils.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

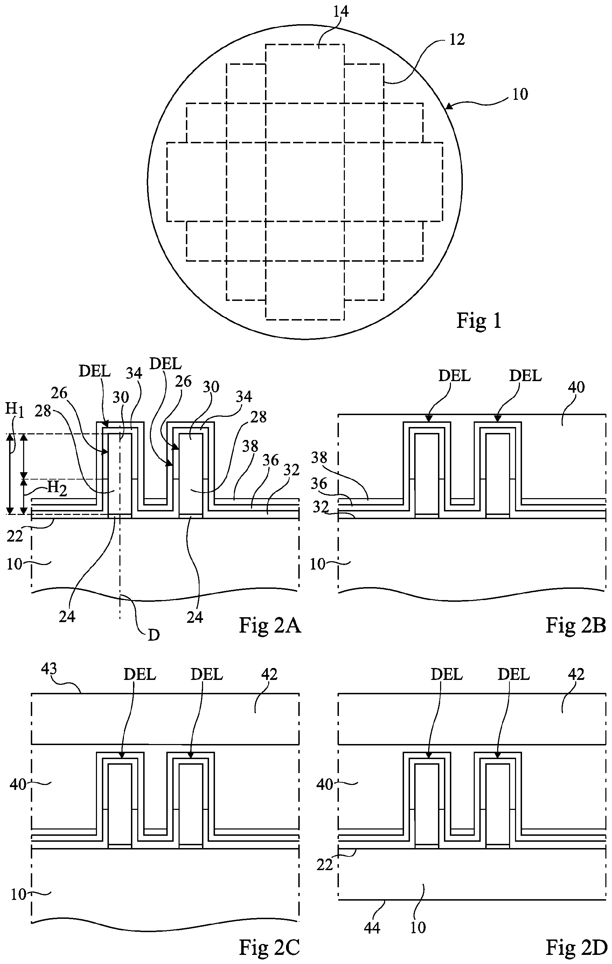

La figure 1 est une vue de dessus, partielle et schématique, d'une plaque 10 d'un substrat semiconducteur sur lequel sont formés des fils. A titre d'exemple, il s'agit d'une plaque de silicium monocristallin ayant une épaisseur initiale comprise entre 500 µm et 1500 µm, par exemple d'environ 725 µm et ayant un diamètre compris entre 100 mm et 300 mm, par exemple d'environ 200 mm. De façon avantageuse, il s'agit d'une plaque de silicium habituellement utilisée dans les procédés de fabrication de circuits en microélectronique, notamment à base de transistors à effet de champ à grille métal-oxyde ou transistor MOS. A titre de variante, on peut utiliser tout autre semiconducteur monocristallin compatible avec les procédés de fabrication en microélectronique comme le germanium. De préférence, le substrat semiconducteur est dopé de façon à baisser la résistivité électrique du substrat à un niveau acceptable de résistance série de la diode électroluminescente et à une résistivité proche de celle des métaux, de préférence inférieure à quelques mohm.cm.

Plusieurs dispositifs optoélectroniques 14 à diodes électroluminescentes sont formés simultanément sur la plaque 10. Les lignes en traits pointillés 12 représentent un exemple de limites de séparation entre les dispositifs optoélectroniques 14. Le nombre de diodes électroluminescentes peut être différent selon les dispositifs optoélectroniques 14. Les dispositifs optoélectroniques 14 peuvent occuper des portions de la plaque 10 ayant des surfaces différentes. La séparation des dispositifs optoélectroniques 14 est réalisée par des étapes de découpe de la plaque 10 selon des chemins de découpe représentés par les lignes 12.

Selon un mode de réalisation, le procédé de fabrication des dispositifs optoélectroniques 14 comprenant des diodes électroluminescentes formées par des éléments tridimensionnels, notamment des fils semiconducteurs, comprend les étapes suivantes :
formation des diodes électroluminescentes des dispositifs optoélectroniques sur une première face de la plaque 10 ;
protection de l'ensemble des diodes électroluminescentes par une couche d'encapsulation ;
réalisation de plots de contact pour la polarisation des diodes électroluminescentes pour chaque dispositif optoélectronique du côté opposé à la couche d'encapsulation ; et
découpe de la plaque 10 pour séparer les dispositifs optoélectroniques.

La couche d'encapsulation protège les diodes électroluminescentes pendant les étapes de formation des plots de contact et est conservée après la séparation des dispositifs optoélectroniques. La couche d'encapsulation continue à protéger les diodes électroluminescentes après la découpe du substrat. Il n'est alors pas nécessaire de prévoir, pour chaque dispositif optoélectronique, un boîtier de protection des diodes électroluminescentes, fixé au dispositif après la séparation des dispositifs optoélectroniques. L'encombrement du dispositif optoélectronique peut être réduit.

De plus, l'étape de protection des diodes électroluminescentes des dispositifs optoélectroniques 14 est réalisée par encapsulation des fils dans une couche d'encapsulation qui est déposée sur la totalité de la plaque 10 avant l'étape de découpe de la plaque 10. Cette étape est donc réalisée une seule fois, pour l'ensemble des dispositifs optoélectroniques 14 formés sur la plaque 10. Le coût de fabrication de chaque dispositif optoélectronique est donc réduit.

Ainsi, l'encapsulation est réalisée entièrement à l'échelle de la plaque après les étapes de fabrication des microfils ou nanofils. Cette encapsulation collective à l'échelle de la plaque permet de réduire le nombre d'étapes dédiées à l'encapsulation et donc le coût de l'encapsulation. De plus, la surface du composant optoélectronique final encapsulé est quasiment identique à celle de la zone active de la puce participant à l'émission de lumière, ce qui permet de réduire les dimensions du composant optoélectronique.

Les figures 2A à 2F sont des coupes, partielles et schématiques, de structures obtenues correspondant à un dispositif optoélectronique à des étapes successives d'un mode de réalisation d'un procédé de fabrication de dispositifs optoélectroniques réalisés à partir de fils tels que décrits précédemment et adaptés à l'émission d'un rayonnement électromagnétique. Les figures 2A à 2F correspondent à l'un des dispositifs optoélectroniques formés sur le substrat 10.

En figure 2A, on a représenté une structure comprenant, du bas vers le haut en figure 2A :
le substrat semiconducteur 10 comprenant une face supérieure 22 ;
des plots de germination 24 favorisant la croissance de fils et disposés sur la face 22 ;
des fils 26 (deux fils étant représentés) de hauteur H₁, chaque fil 26 étant en contact avec l'un des plots de germination 24, chaque fil 26 comprenant une portion inférieure 28, de hauteur H₂, en contact avec le plot de germination 24 et une portion supérieure 30, de hauteur H₃, prolongeant la portion inférieure 28 ;
une couche isolante 32 s'étendant sur la face 22 du substrat 10 et sur les flancs latéraux de la portion inférieure 28 de chaque fil 26 ;
une coque 34 comprenant un empilement de couches semiconductrices recouvrant chaque portion supérieure 30 ;
une couche 36 formant une première électrode recouvrant chaque coque 30 et s'étendant, en outre, sur la couche isolante 32 ; et
une couche conductrice 38 recouvrant la couche d'électrode 36 entre les fils 26 mais ne s'étendant pas sur les fils 26.

L'ensemble formé par chaque fil 26, le plot de germination 24 et la coque 34 associés constitue une diode électroluminescente DEL. La base de la diode DEL correspond au plot de germination 24. La coque 34 comprend notamment une couche active qui est la couche depuis laquelle est émise la majorité du rayonnement électromagnétique fourni par la diode électroluminescente DEL.

Le substrat 10 peut correspondre à une structure monobloc ou correspondre à une couche recouvrant un support constitué d'un autre matériau. Le substrat 10 est, par exemple, un substrat semiconducteur, de préférence un substrat semiconducteur compatible avec les procédés de fabrication mis en oeuvre en microélectronique, par exemple un substrat en silicium, en germanium ou un alliage de ces composés. Le substrat est dopé de façon que la résistivité du substrat soit inférieure à quelques mohm.cm.

De préférence, le substrat 10 est un substrat semiconducteur, tel qu'un substrat en silicium. Le substrat 10 peut être dopé d'un premier type de conductivité, par exemple dopé de type N. La face 22 du substrat 20 peut être une face <100>.

Les plots de germination 24, appelés également îlots de germination, sont en un matériau favorisant la croissance des fils 26. A titre de variante, les plots de germination 24 peuvent être remplacés par une couche de germination recouvrant la face 22 du substrat 10. Dans le cas de plots de germination, un traitement peut, en outre, être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique.

A titre d'exemple, le matériau composant les plots de germination 24 peut être un nitrure, un carbure ou un borure d'un métal de transition de la colonne IV, V ou VI du tableau périodique des éléments ou une combinaison de ces composés. A titre d'exemple, les plots de germination 24 peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci.

Les plots de germination 24 peuvent être dopés du même type de conductivité que le substrat 10 ou du type de conductivité opposé.

La couche isolante 32 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant. A titre d'exemple, l'épaisseur de la couche isolante 32 est comprise entre 5 nm et 800 nm, par exemple égale à environ 30 nm.

Les fils 26 peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 26 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 26 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 26 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 26 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 26 peut être compris entre 50 nm et 2,5 µm. La hauteur H₁ de chaque fil 26 peut être comprise entre 250 nm et 50 µm.

Chaque fil 26 peut avoir une structure semiconductrice allongée selon un axe D sensiblement perpendiculaire à la face 22. Chaque fil 26 peut avoir une forme générale cylindrique.

Les axes de deux fils 26 adjacents peuvent être distants de 0,5 µm à 10 µm et de préférence de 1,5 µm à 4 µm. A titre d'exemple, les fils 26 peuvent être régulièrement répartis. A titre d'exemple, les fils 26 peuvent être répartis selon un réseau hexagonal.

A titre d'exemple, la portion inférieure 28 de chaque fil 26 est principalement constituée du composé III-N, par exemple du nitrure de gallium, dopé du premier type de conductivité, par exemple au silicium. La portion inférieure 28 s'étend sur une hauteur H₂ qui peut être comprise entre 100 nm et 25 µm.

A titre d'exemple, la portion supérieure 30 de chaque fil 26 est au moins partiellement réalisée dans un composé III-N, par exemple du GaN. La portion supérieure 30 peut être dopée du premier type de conductivité, ou ne pas être intentionnellement dopée. La portion supérieure 30 s'étend sur une hauteur H₃ qui peut être comprise entre 100 nm et 25 µm.

Dans le cas d'un fil 26 composé principalement de GaN, la structure cristalline du fil 26 peut être du type wurtzite, le fil s'étendant selon l'axe C. La structure cristalline du fil 26 peut également être du type cubique.

La coque 34 peut comprendre un empilement d'une couche active recouvrant la portion supérieure 30 du fil 26 associé et d'une couche de liaison entre la couche active et l'électrode 36.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche de liaison peut correspondre à une couche semiconductrice ou à l'empilement de couches semiconductrices et permet la formation d'une jonction P-N ou P-I-N avec la couche active et/ou la portion supérieure 30. Elle permet l'injection de trous dans la couche active via l'électrode 36. L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et une couche supplémentaire, pour assurer un bon contact électrique entre l'électrode 36 et la couche active, par exemple en nitrure de gallium (GaN) en contact avec la couche de blocage d'électrons et avec l'électrode 36. La couche de liaison peut être dopée du type de conductivité opposé à celui de la portion 30, par exemple dopée de type P.

L'électrode 36 est adaptée à polariser la couche active de chaque fil 26 et laisser passer le rayonnement électromagnétique émis par les diodes électroluminescentes DEL. Le matériau formant l'électrode 36 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 36 a une épaisseur comprise entre 10 nm et 150 nm en fonction de la longueur d'onde d'émission souhaitée.

La couche conductrice 38 peut être une couche unique ou correspondre à un empilement de deux couches ou de plus de deux couches. La couche conductrice 38 peut, en outre, être adaptée à réfléchir au moins en partie le rayonnement émis par les diodes électroluminescentes DEL. A titre d'exemple, la couche conductrice 38 correspond à une monocouche métallique. Selon un autre exemple, la couche conductrice 38 correspond à un empilement de couches comprenant, par exemple, une couche métallique recouverte d'une couche diélectrique ou de plusieurs couches diélectriques. La couche métallique de la couche conductrice 38 peut être formée sur une couche d'accroche, par exemple en titane. A titre d'exemple, le matériau composant la couche métallique de la couche conductrice 38 (monocouche ou multicouche) peut être l'aluminium, un alliage à base d'aluminium, notamment AlSi_{z}, AlₓCu_{y} (par exemple avec x égal à 1 et y égal à 0,8 %), l'argent, l'or, le nickel, le chrome, le rhodium, le ruthénium, le palladium ou un alliage de deux de ces composés ou de plus de deux de ces composés. A titre d'exemple, la couche conductrice 38 (monocouche ou multicouche) a une épaisseur comprise entre 100 nm et 2000 nm.

Un mode de réalisation d'un procédé de fabrication permettant l'obtention de la structure représentée en figure 2A comprend les étapes suivantes :
(1) Formation sur la face 22 du substrat 10 des plots de germination 24.
   Les plots de germination 24 peuvent être obtenus par un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels l'évaporation ou la pulvérisation cathodique réactive peuvent être utilisés.
   Lorsque les plots de germination 24 sont en nitrure d'aluminium, ils peuvent être sensiblement texturés et posséder une polarité préférentielle. La texturation des plots 24 peut être obtenue par un traitement supplémentaire réalisé après le dépôt des plots de germination 24. Il s'agit, par exemple, d'un recuit sous flux d'ammoniac (NH₃).
(2) Protection des portions de la face 22 du substrat 10 non recouvertes des plots de germination 24 pour éviter la croissance ultérieure de fils sur ces portions. Ceci peut être obtenu par une étape de nitruration qui entraîne la formation, en surface du substrat 10, entre les plots de germination 24 de régions de nitrure de silicium (par exemple Si₃N₄).
(3) Croissance de la portion inférieure 28 de chaque fil 26 sur la hauteur H₂. Chaque fil 26 croît depuis le sommet du plot de germination 24 sous-jacent.
   Le procédé de croissance des fils 26 peut être un procédé du type CVD, MOCVD, MBE, GSMBE, PAMBE, ALE, HVPE. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.
   A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).
   Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).
   A titre d'exemple, dans le cas où la portion inférieure 28 est en GaN fortement dopée de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.
   La présence de silane parmi les gaz précurseurs entraîne l'incorporation de silicium au sein du composé GaN. On obtient ainsi une portion inférieure 28 dopée de type N. En outre, ceci se traduit par la formation d'une couche de nitrure de silicium, non représentée, qui recouvre le pourtour de la portion 28 de hauteur H₂, à l'exception du sommet au fur et à mesure de la croissance de la portion 28.
(4) Croissance de la portion supérieure 30 de hauteur H₃ de chaque fil 26 sur le sommet de la portion inférieure 28. Pour la croissance de la portion supérieure 30, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 30 peut être dopée de type N en raison de la diffusion dans cette portion active de dopants provenant des portions passivées adjacentes ou en raison du dopage résiduel du GaN.
(5) Formation par épitaxie, pour chaque fil 26, des couches composant la coque 34. Compte tenu de la présence de la couche de nitrure de silicium recouvrant le pourtour de la portion inférieure 28, le dépôt des couches composant la coque 34 ne se produit que sur la portion supérieure 30 du fil 26.
(6) Formation de la couche isolante 32, par exemple par dépôt conforme d'une couche isolante sur la totalité de la structure obtenue à l'étape (5) et gravure de cette couche pour exposer la coque 34 de chaque fil 26. Dans le mode de réalisation décrit précédemment, la couche isolante 32 ne recouvre pas la coque 34. A titre de variante, la couche isolante 32 peut recouvrir une partie de coque 34. En outre, la couche isolante 32 peut être réalisée avant la formation de la coque 34.
(7) Formation de l'électrode 36, par exemple par dépôt conforme.
(8) Formation de la couche conductrice 38 par exemple par dépôt physique en phase vapeur (PVD, acronyme anglais pour Physical Vapor Déposition) sur l'ensemble de la structure obtenue à l'étape (7) et gravure de cette couche pour exposer chaque fil 26. La figure 2B représente la structure obtenue après avoir déposé une couche d'encapsulation 40 sur la totalité de la plaque 10. L'épaisseur maximale de la couche d'encapsulation 40 est comprise entre 12 µm et 1000 µm, par exemple d'environ 50 µm, de sorte que la couche d'encapsulation 40 recouvre complètement l'électrode 36 au sommet des diodes électroluminescentes DEL. La couche d'encapsulation 40 est réalisée en un matériau isolant au moins partiellement transparent.

La couche d'encapsulation 40 peut être réalisée en un matériau inorganique au moins partiellement transparent.

A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. Le matériau inorganique peut alors être déposé par CVD basse température, notamment à une température inférieure à 300°C-400°C, par exemple par PECVD (acronyme anglais pour Plasma Enhanced Chemical Vapor Déposition).

La couche d'encapsulation 40 peut être réalisée en un matériau organique au moins partiellement transparent. A titre d'exemple, la couche d'encapsulation 40 est un polymère silicone, un polymère époxyde, un polymère acrylique ou un polycarbonate. La couche d'encapsulation 40 peut alors être déposée par un procédé de dépôt à la tournette, par un procédé d'impression par jet ou par un procédé de sérigraphie. Un procédé de dispense par doseur temps/pression ou par doseur volumétrique est également possible en mode automatique sur des équipements programmables.

La figure 2C représente la structure obtenue après la fixation d'un support supplémentaire 42, appelée poignée, sur la couche d'encapsulation 40. A titre d'exemple, la poignée a une épaisseur comprise entre 200 µm et 1000 µm.

Selon un mode de réalisation, la poignée 42 est destinée à être conservée sur les dispositifs optoélectroniques une fois découpés. La poignée 42 est alors en un matériau au moins en partie transparent. Il peut s'agir de verre, notamment un verre borosilicate, par exemple du pyrex, ou de saphir. Un observateur perçoit les rayons lumineux émis par les diodes électroluminescentes DEL qui traversent la face 43 de la poignée 42 opposée à la couche d'encapsulation 40.

Selon un autre mode de réalisation, la poignée 42 est destinée à être retirée à une étape ultérieure du procédé de fabrication. Dans ce cas, la poignée 42 peut être réalisée en tout type de matériau compatible avec les étapes ultérieures du procédé de fabrication. Il peut s'agir de silicium ou tout substrat plan compatible avec les critères de planéité de la microélectronique.

La fixation de la poignée 42 à la couche d'encapsulation 40 peut être réalisée par tout moyen, par exemple par collage, par exemple en utilisant une couche de colle organique réticulable en température, non représentée, ou bien encore par collage moléculaire (collage direct) ou collage optique par colle durcie aux rayonnements ultra-violet. Lorsque la couche d'encapsulation 40 est en un matériau organique, ce matériau peut servir de colle pour la poignée 42. Lorsqu'une couche de colle est employée, celle-ci doit être au moins partiellement transparente.

La figure 2D représente la structure obtenue après une étape d'amincissement du substrat 10. Après amincissement, l'épaisseur du substrat 10 peut être comprise entre 20 µm et 200 µm, par exemple d'environ 30 µm. L'étape d'amincissement peut être réalisée par une ou plus d'une étape de meulage, de gravure, et/ou par des procédés de planarisation mécano-chimique ou CMP (acronyme anglais pour Chemical Mechanical Polishing). Le substrat 10 aminci comprend une face 44 opposée à la face 22. Les faces 22 et 44 sont de préférence parallèles.

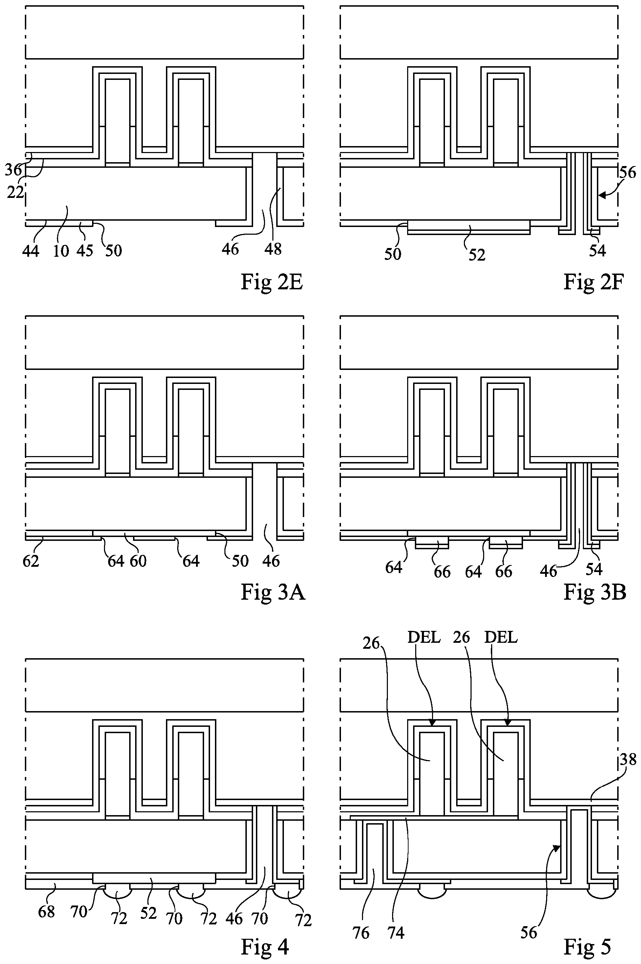

La figure 2E représente la structure obtenue après les étapes suivantes :
- formation d'une couche isolante 45, par exemple en oxyde de silicium (SiO₂) ou en nitrure et oxyde de silicium (SiON), sur la face arrière du substrat 10. La couche isolante 45 est, par exemple, réalisée par dépôt conforme par PECVD ;
- gravure, pour chaque dispositif optoélectronique, d'au moins une ouverture 46 traversant la couche isolante 45, le substrat 10, la couche isolante 32 et la couche d'électrode 36 pour exposer une portion de la couche métallique 38. La gravure du substrat 10 peut être une gravure ionique réactive profonde (DRIE, acronyme anglais pour Deep Reactive Ion Etching). La gravure de la portion de la couche isolante 32 est aussi réalisée par gravure plasma avec la chimie adaptée à la couche isolante 32. En même temps, on peut graver la couche d'électrode 36. A titre de variante, la couche 36 peut être retirée des zones de formation des vias 46 avant l'étape de formation de la couche métallique 38. L'ouverture 46 peut avoir une section droite circulaire. Le diamètre de l'ouverture 46 peut alors être compris entre 5 µm et 200 µm en fonction de la taille du composant unitaire optoélectronique 14 tel que représenté en figure 1, par exemple environ 15 µm. Plusieurs ouvertures circulaires 46 peuvent alors être réalisées simultanément afin de créer des connexions en parallèle. Cela permet de réduire la résistance des connexions. Ces connexions peuvent être disposées à la périphérie de la zone où sont formées les diodes électroluminescentes DEL. A titre de variante, l'ouverture 46 peut correspondre à une tranchée, s'étendant, par exemple, le long d'au moins un côté du dispositif optoélectronique. De préférence, la largeur de la tranchée est comprise entre 15 µm et 200 µm en fonction de la taille du composant unitaire optoélectronique 14 tel que représenté en figure 1, par exemple environ 15 µm ;
- formation d'une couche isolante 48, par exemple en SiO2 ou SiON sur les parois internes de l'ouverture 46 et, éventuellement sur la couche 45, la partie de la couche 48 recouvrant la couche 45 n'étant pas représentée sur les figures. La couche isolante 48 est, par exemple, réalisée par dépôt conforme par PECVD. La couche isolante 48 a une épaisseur comprise entre 200 nm et 5000 nm, par exemple d'environ 3 µm ;
- gravure de la couche isolante 48 pour exposer la couche conductrice 38 au fond de l'ouverture 46. Il s'agit d'une gravure anisotrope ; et
- gravure d'au moins une ouverture 50 dans la couche isolante 45 pour exposer une portion de la face 44 du substrat 10. Pour réaliser cette gravure, l'ouverture 46 peut être temporairement bouchée, par exemple par une résine.

La figure 2F représente la structure obtenue après la formation d'une deuxième électrode 52 dans l'ouverture 50 et d'une couche conductrice 54 sur la couche isolante 48, la couche conductrice 54 recouvrant les parois internes de l'ouverture 46 jusqu'à venir au contact de la portion métallique 36 et s'étendant sur la face 44 autour de l'ouverture 46. L'électrode 52 et la couche conductrice 54 peuvent comprendre un empilement de deux couches, comme cela est représenté sur les figures, ou plus de deux couches. Il s'agit par exemple de TiCu ou de TiAl. Cette couche peut être recouverte d'une autre couche métallique, par exemple de l'or, du cuivre ou des alliages eutectiques (Ni/Au ou Sn/Ag/Cu) en vue de la mise en oeuvre d'un procédé de brasage. La deuxième électrode 52 et la couche conductrice 54 peuvent être formées, notamment dans le cas du cuivre, par dépôt électrochimique (ECD, acronyme anglais pour Electro-Chemical Déposition). L'épaisseur de la couche d'électrode 52 et la couche conductrice 54 peut être comprise entre 1 µm et 10 µm, par exemple d'environ 5 µm.

L'ensemble comprenant l'ouverture 46, la couche isolante 48 et la couche conductrice 54 forment une connexion verticale 56 ou TSV (acronyme anglais pour Through Silicon Via). La connexion verticale 56 permet d'assurer la polarisation de la première électrode 36 depuis la face arrière du substrat 10 tandis que la polarisation des fils 26 est obtenue par la deuxième électrode 52 au travers du substrat 10.

Les figures 3A et 3B sont des coupes, partielles et schématiques, de structures obtenues à des étapes successives d'un autre mode de réalisation d'un procédé de fabrication de dispositifs optoélectroniques à fils qui comprend l'ensemble des étapes décrites précédemment en relation avec les figures 2A à 2E.

La figure 3A représente la structure obtenue après les étapes suivantes :
- formation dans l'ouverture 50 de la couche isolante 44 d'un plot conducteur 60 ;
- dépôt d'une couche isolante 62 recouvrant notamment le plot métallique 60. La couche isolante 62 peut être en oxyde de silicium ou en nitrure de silicium ou correspondre à un empilement de deux couches empilées ou davantage et avoir une épaisseur comprise entre 200 nm et 1000 nm ; et
- gravure d'ouvertures 64 dans la couche isolante 62 pour exposer des portions du plot conducteur 60.

La figure 3B représente la structure obtenue après des étapes analogues à ce qui a été décrit précédemment en relation avec la figure 2F pour former des deuxièmes électrodes 66 dans les ouvertures 64 et la couche conductrice 54 dans l'ouverture 46.

Le mode de réalisation décrit en relation avec les figures 3A et 3B permet avantageusement d'ajuster les positions et les dimensions des deuxièmes électrodes 66.

La figure 4 illustre un autre mode de réalisation d'un procédé de fabrication comprenant, après les étapes décrites précédemment en relation avec la figure 2F, les étapes suivantes :
- dépôt d'une couche isolante 68 recouvrant notamment le plot 52 et remplissant l'ouverture 46. Il peut s'agir d'un polymère isolant, par exemple une résine photosensible BCB (acronyme pour Benzocyclobutène) d'épaisseur comprise entre 2 µm et 20 µm ou d'un oxyde de silicium ou de nitrure de silicium ou les deux et avoir une épaisseur comprise entre 200 nm et 1000 nm ;
- formation d'ouvertures 70 dans la couche isolante 68 pour exposer des portions de la deuxième électrode 52 et de la couche conductrice 54. Il peut s'agir d'une gravure du type plasma lorsque la couche isolante 68 est composée d'un matériau inorganique ou des étapes d'insolation et de développement lorsque la couche isolante 68 est composée d'une résine photosensible ; et
- formation de billes conductrices 72 dans les ouvertures 70. Les billes 72 sont en matériaux compatibles avec les opérations de brasage dans l'industrie électronique, par exemple des alliages à base d'étain ou d'or. Les billes 72 peuvent être utilisées pour la fixation du dispositif optoélectronique sur un support, non représenté.

Dans les modes de réalisation décrits précédemment, le courant circule entre la première électrode 36 et la deuxième électrode 52, 66 au travers du substrat 10.

La figure 5 illustre un autre mode de réalisation dans lequel les diodes électroluminescentes sont polarisées directement aux pieds des fils 26. Les fils 26 sont formés sur une couche de germination 74 qui est alors commune à un ensemble de diodes électroluminescentes DEL du dispositif optoélectronique. Une connexion verticale 76 est formée dans le substrat 10, par exemple de façon analogue à la connexion verticale 56, à la différence que la connexion verticale 76 est connectée à la couche de germination 74.

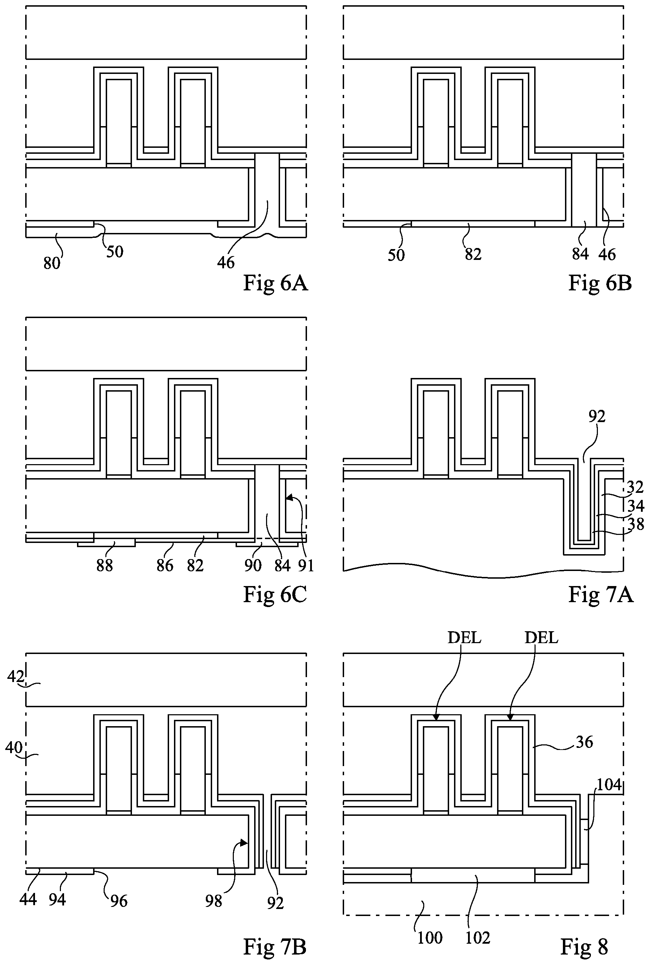

Les figures 6A à 6C sont des coupes, partielles et schématiques, de structures obtenues à des étapes successives d'un autre mode de réalisation d'un procédé de fabrication de dispositifs optoélectroniques à fils qui comprend l'ensemble des étapes décrites précédemment en relation avec les figures 2A à 2E.

La figure 6A représente la structure obtenue après un dépôt d'une couche métallique 80 épaisse, par exemple du cuivre. Il peut s'agir d'un dépôt ECD. L'épaisseur de la couche 80 est, par exemple, de l'ordre de 10 µm. La couche métallique 80 est suffisamment épaisse pour remplir l'ouverture 46.

La figure 6B représente la structure obtenue après une étape de polissage de la couche métallique 80 pour délimiter une portion métallique 82 dans l'ouverture 50 et une portion métallique 84 dans l'ouverture 46. L'étape de planarisation de la couche 80 peut être réalisée par CMP.

La figure 6C représente la structure obtenue après des étapes analogues à celles décrites précédemment en relation avec les figures 3A et 3B comprenant le dépôt d'une couche isolante 86 sur la totalité de la face arrière du substrat 10 et la formation d'une deuxième électrode 88 traversant la couche 86 au contact de la portion métallique 82 et d'un plot conducteur 90 traversant la couche 86 au contact de la portion métallique 84. Une couche de passivation, notamment en polymère, peut être déposée sur la structure du côté de la face arrière, des ouvertures étant formées dans la couche de passivation pour exposer l'électrode 88 et le plot conducteur 90.

L'ensemble comprenant l'ouverture 46, la couche isolante 48, la portion métallique 84 et le plot métallique 90 forme un TSV 91 qui joue le même rôle que le TSV 56 décrit précédemment. Les plots métalliques 88 et 90 servent à l'assemblage du composant optoélectronique encapsulé sur son support final, par exemple un circuit imprimé. Les méthodes d'assemblage peuvent être réalisées par brasage. L'empilement métallique est choisi de telle manière à être compatible avec les opérations de brasage utilisées dans l'industrie de l'électronique et notamment avec la brasure utilisée, par exemple en Cu avec finition OSP (acronyme anglais pour Organic Solderability Preservative) ou finition Ni-Au (par voie chimique (ENIG, acronyme anglais pour Electroless nickel immersion gold) ou électrochimique), Sn, Sn-Ag, Ni-Pd-Au, Sn-Ag-Cu, Ti-Wn-Au ou ENEPIG (acronyme anglais pour Electroless Nickel / Electroless Palladium / Immersion Gold).

Les figures 7A et 7B sont des coupes, partielles et schématiques, de structures obtenues à des étapes successives d'un autre mode de réalisation d'un procédé de fabrication de dispositifs optoélectroniques à fils.

Les étapes initiales peuvent comprendre les étapes décrites précédemment en relation avec la figure 2A à la différence que, avant les étapes (5) à (7), une ouverture 92 est formée dans le substrat 10. L'ouverture 92 peut être formée par une gravure du type DRIE. La profondeur de l'ouverture 92 est strictement supérieure à l'épaisseur du substrat 10 après l'étape d'amincissement. A titre d'exemple, la profondeur de l'ouverture 92 est comprise entre 10 µm et 200 µm, par exemple de l'ordre de 35 µm.

Lors de la mise en oeuvre des étapes (5) à (7), la couche isolante 32, l'électrode 36 et la couche conductrice 38 sont formées également dans l'ouverture 92.

La figure 7B représente la structure obtenue après la réalisation des étapes suivantes :
- dépôt de la couche d'encapsulation 40 de façon analogue à ce qui a été décrit précédemment en relation avec la figure 2B. La couche d'encapsulation 40 pénètre dans l'ouverture 92 partiellement ou totalement ;
- report de la poignée 42 de façon analogue à ce qui a été décrit précédemment en relation avec la figure 2C ;
- amincissement du substrat 10 de façon analogue à ce qui a été décrit précédemment en relation avec la figure 2D jusqu'à atteindre l'ouverture 92 ;
- formation d'une couche isolante 94 sur la face arrière 44 du substrat 10 en protégeant l'ouverture 92 ; et
- formation d'une ouverture 96 dans la couche isolante 94 pour exposer une portion du substrat 10.

L'ensemble comprenant l'ouverture 92 et les portions de la couche isolante 32, de la couche d'électrode 36 et de la couche conductrice 38 s'étendant dans l'ouverture 92 forme un TSV 98 qui joue le même rôle que le TSV 56 décrit précédemment.

Les étapes ultérieures du procédé peuvent être analogues à ce qui a été décrit précédemment en relation avec la figure 2F.

La figure 8 représente un mode de réalisation dans lequel au moins l'une des découpes du substrat 10 est réalisée au niveau d'un TSV qui peut correspondre à l'un des TSV 56, 91 ou 98 décrits précédemment. La découpe expose une partie de la couche conductrice qui s'étend sur les parois internes du TSV. La polarisation de la première électrode 36 des diodes électroluminescentes DEL peut alors être réalisée depuis le côté du dispositif optoélectronique. A titre d'exemple, le dispositif optoélectronique peut être fixé à un support 100 par un plot de connexion 102 au contact de la face arrière du substrat 14 et par un plot de connexion 104 au contact de la partie latérale exposée du TSV.

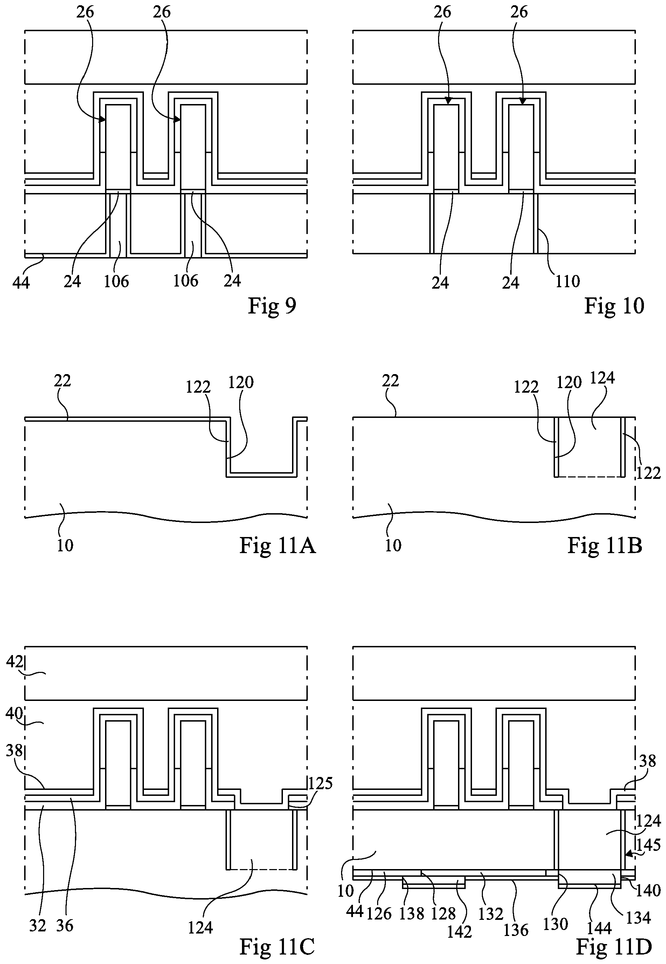

La figure 9 représente un mode de réalisation dans lequel un TSV 106 est prévu au niveau de chaque fil 26 du dispositif optoélectronique. Chaque TSV 106 vient au contact du plot de germination 24 du fil 26 associé. Les TSV 106 peuvent ne pas être connectés les uns aux autres. Les fils 26 peuvent alors être polarisés séparément. A titre de variante, une électrode, non représentée, prévue du côté de la face arrière 44 du substrat 10, peut être connectée à l'ensemble des connexions verticales 106 associées à un même dispositif optoélectronique.

La figure 10 représente un mode de réalisation dans lequel un TSV 110 vient au contact simultanément des plots de germination 24 de plusieurs fils 26. Les connexions verticales 106, 110 peuvent être réalisées selon l'un quelconque des procédés de fabrication décrits précédemment pour la réalisation des TSV 56, 91 et 98.

Les figures 11A à 11D sont des coupes, partielles et schématiques, de structures obtenues à des étapes successives d'un autre mode de réalisation d'un procédé de fabrication de dispositifs optoélectroniques à fils.

Les figures 11A et 11B représentent des structures obtenues après la réalisation d'étapes avant l'étape (1) décrite précédemment en relation avec la figure 2A.

La figure 11A représente la structure obtenue après les étapes suivantes :
- gravure d'une ouverture 120 dans le substrat 10. L'ouverture 120 peut être formée par une gravure de type gravure ionique réactive, par exemple une gravure DRIE. La profondeur de l'ouverture 120 est strictement supérieure à l'épaisseur visée du substrat 10 après l'étape d'amincissement. A titre d'exemple, la profondeur de l'ouverture 120 est comprise entre 10 µm et 200 µm, par exemple environ 35 µm. La distance entre les parois latérales de l'ouverture 120 est comprise entre 1 et 10 µm et par exemple 2 µm ; et
- formation d'une portion isolante 122, par exemple en oxyde de silicium, sur les parois latérales de l'ouverture 120, par exemple par un procédé d'oxydation thermique. A cette étape, une portion isolante peut également se former au fond de l'ouverture 120 et sur le reste du substrat 10. L'épaisseur de la portion isolante peut être comprise entre 100 nm et 3000 nm, par exemple environ 200 nm.

La figure 11B représente la structure obtenue après la mise en oeuvre des étapes suivantes :
- gravure anisotrope de la portion isolante au fond de l'ouverture 120 et de la portion isolante recouvrant la face 22 du substrat 10 pour conserver les portions isolantes 122 sur les flancs latéraux de l'ouverture 120. A titre d'exemple, la gravure de la portion isolante recouvrant la face 22 du substrat 10 peut être omise. Dans ce cas, un masque réalisé par photolithographie peut être prévu pour protéger lesdites portions isolantes non gravées ;
- remplissage de l'ouverture 120 par un matériau de remplissage, par exemple du silicium polycristallin, du tungstène ou matériau métallique réfractaire qui supporte le budget thermique durant les étapes réalisées à températures élevées décrites précédemment notamment en relation avec les étapes 2A à 2D, déposé par exemple par LPCVD. Le silicium polycristallin a, de façon avantageuse, un coefficient de dilatation thermique proche du silicium et permet ainsi de réduire les contraintes mécaniques durant les étapes réalisées à températures élevées décrites précédemment notamment en relation avec les étapes 2A à 2D ;
- retrait de la couche du matériau de remplissage, par exemple un procédé de type CMP. Dans le cas où la gravure de la portion isolante recouvrant la face 22 du substrat 10 a été omise pendant la gravure anisotrope de la portion isolante au fond de l'ouverture 122, ladite couche non gravée peut avantageusement être utilisée comme couche d'arrêt pendant le retrait de la couche du matériau de remplissage. Dans ce cas, le retrait de la couche du matériau de remplissage est suivi par une étape de gravure de la portion isolante recouvrant la face 22 du substrat 10. Une portion 124 du matériau de remplissage est ainsi obtenue.

La figure 11C représente la structure obtenue après la mise en oeuvre d'étapes analogues à ce qui a été décrit précédemment en relation avec les figures 2A à 2D à la différence qu'il comprend, avant la formation de la couche conductrice 38, une étape de gravure d'une ouverture 125 dans la couche d'électrode 36 et de la couche isolante 32 de sorte que la couche conductrice 38 vienne au contact de la portion 124.

La figure 11D représente la structure obtenue après la mise en oeuvre des étapes suivantes, de façon analogue à ce qui a été décrit précédemment en relation avec les figures 7B, 3A et 3B :
- amincissement du substrat 10 jusqu'à atteindre la portion conductrice 124 ;
- formation d'une couche isolante 126 sur la face arrière 44 du substrat 10 ;
- formation, dans la couche isolante 126 d'une ouverture 128 pour exposer une portion de la face arrière 44 du substrat 10 et d'une ouverture 130 pour exposer la portion conductrice 124 ;
- formation d'un plot conducteur 132 dans l'ouverture 128 au contact du substrat 10 et d'un plot conducteur 134 dans l'ouverture 130 au contact de la portion conductrice 124 ;
- formation d'une couche isolante 136 recouvrant la couche isolante 126 et les plots conducteurs 132, 134 ;
- formation, dans la couche isolante 136 d'une ouverture 138 pour exposer une portion du plot conducteur 132 et d'une ouverture 140 pour exposer le plot conducteur 134 ; et
- formation d'une deuxième électrode 142 dans l'ouverture 138 au contact du plot conducteur 132 et d'un plot conducteur 144 dans l'ouverture 130 au contact du plot conducteur 134.

L'ensemble comprenant la portion 124 du matériau de remplissage délimitée par les portions isolantes 122 forme un TSV 145 qui joue le même rôle que le TSV 56 décrit précédemment. La partie conductrice 124 qui relie le plot 144 à la couche métallique 38 est assurée par la portion 124 du matériau de remplissage.

A titre de variante, la couche isolante 126 peut ne pas être présente et les plots conducteurs 132, 144 peuvent être formés directement sur le substrat 10.

Selon une autre variante, au lieu de former une portion 124 d'un matériau de remplissage isolée électriquement du substrat 10 par des portions isolantes, le procédé peut comprendre des étapes de formation de tranchées d'isolation délimitant une portion du substrat qui joue alors le rôle de la portion 124. De préférence, on utilise alors du silicium fortement dopé, par exemple ayant une concentration de dopants supérieure ou égale à 10¹⁹ atomes/cm³, pour diminuer la résistance de cette connexion. Cette partie conductrice peut être réalisée par une ou plusieurs tranchées de silicium autour de la zone active ou par un ou des via de silicium isolé électriquement.

Le mode de réalisation décrit précédemment en relation avec les figures 11A à 11D peut être mis en oeuvre pour réaliser les connexions verticales 106 et 110 décrites précédemment en relation avec les figures 9 et 10.

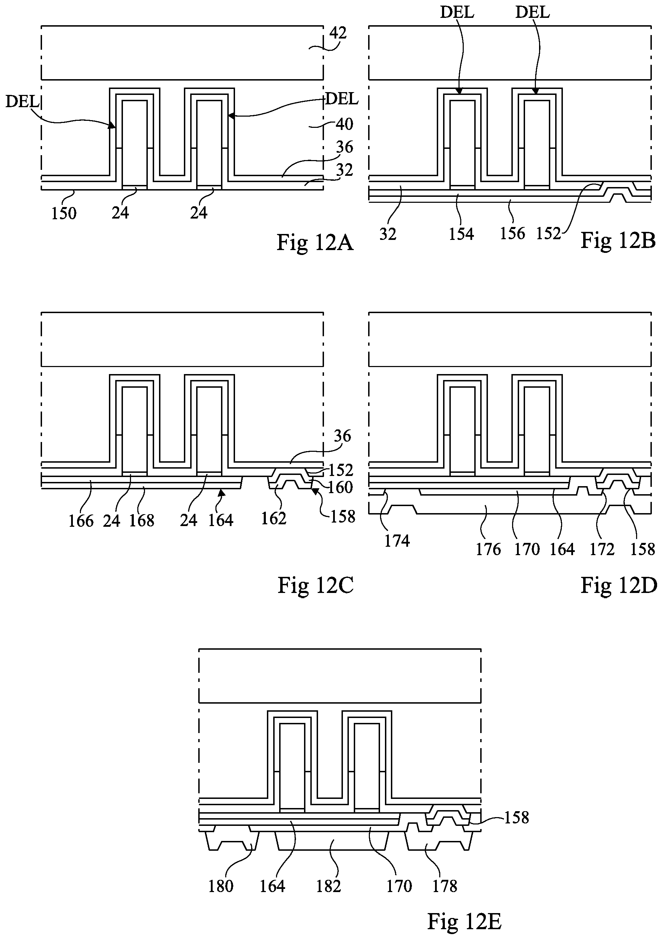

Les figures 12A à 12E sont des coupes, partielles et schématiques, de structures obtenues à des étapes successives d'un autre mode de réalisation d'un procédé de fabrication de dispositifs optoélectroniques à fils. Les étapes initiales peuvent comprendre les étapes décrites précédemment en relation avec les figures 2A à 2C à la différence que la couche conductrice 38 n'est pas présente.

La figure 12A représente la structure obtenue après une étape de retrait du substrat 10. Le retrait du substrat 10 peut être réalisé par une ou plus d'une étape de gravure. On désigne par la référence 150 la face arrière de la structure ainsi exposée après le retrait du substrat. En figure 12A, la gravure est arrêtée sur la couche isolante 32 et sur les plots de germination 24. A titre de variante, le procédé peut, en outre, comprendre le retrait des plots de germination 24.

La figure 12B représente la structure obtenue après la mise en oeuvre des étapes suivantes :
- gravure d'une ouverture 152 dans la couche isolante 32 ;
- dépôt d'une couche miroir 154 sur la face arrière 150 et dans l'ouverture 152 ; et
- dépôt d'une couche conductrice 156 recouvrant la couche miroir 154.

La couche miroir 154 peut être une couche unique ou correspondre à un empilement de deux couches ou plus de deux couches. A titre d'exemple, la couche miroir 154 correspond à une monocouche métallique. Selon un autre exemple, la couche miroir 154 correspond à un empilement de couches comprenant une couche métallique recouverte d'une couche diélectrique ou de plusieurs couches diélectriques. La couche métallique de la couche miroir 154 peut être formée sur une couche d'accroche, par exemple en titane. L'épaisseur de la couche miroir 154 (monocouche ou multicouche) est supérieure à 15 nm, par exemple comprise entre 30 nm et 2 µm. La couche miroir 154 peut être déposée par ECD.

Selon un mode de réalisation, la couche miroir 154 est adaptée à réfléchir au moins en partie le rayonnement émis par les diodes électroluminescentes DEL.

Selon un mode de réalisation, les indices optiques complexes des matériaux composant les plots de germination 24 et la couche miroir 154 (monocouche ou multicouche) et les épaisseurs des plots de germination 24 et de la couche miroir 154 sont sélectionnés pour augmenter la réflectivité moyenne des plots de germination 24 et la couche miroir 154. On appelle réflectivité moyenne d'une couche ou d'un empilement de couches la moyenne du rapport entre l'énergie électromagnétique réfléchie par la couche ou l'empilement de couches sur l'énergie incidente pour tous les angles possibles d'incidence à une longueur d'onde donnée. Il est souhaitable que la réflectivité moyenne soit la plus élevée possible, de préférence supérieure à 80 %.

L'indice optique complexe, également appelé indice de réfraction complexe, est un nombre sans dimension qui caractérise les propriétés optiques d'un milieu, notamment l'absorption et la diffusion. L'indice de réfraction est égal à la partie réelle de l'indice optique complexe. Le coefficient d'extinction, également appelé coefficient d'atténuation, d'un matériau, mesure la perte d'énergie d'un rayonnement électromagnétique traversant ce matériau. Le coefficient d'extinction est égal à l'opposé de la partie imaginaire de l'indice de réfraction complexe. L'indice de réfraction et le coefficient d'extinction d'un matériau peuvent être déterminés, par exemple, par ellipsométrie. Une méthode d'analyse des données ellipsométriques est décrite dans l'ouvrage intitulé "Spectroscopic ellipsometry, Principles and Applications" de Hiroyuki Fujiwara, édité par John Wiley & Sons, Ltd (2007).

A titre d'exemple, le matériau composant la couche métallique de la couche miroir 154 (monocouche ou multicouche) peut être l'aluminium, l'argent, le chrome, le rhodium, le ruthénium, le palladium ou un alliage de deux de ces composés ou de plus de deux de ces composés.

Selon un mode de réalisation, l'épaisseur de chaque plot de germination 24 est inférieure ou égale à 20 nm.

Selon un mode de réalisation, l'indice de réfraction de chaque plot de germination 24 est compris entre 1 et 3 pour une longueur d'onde comprise entre 380 nm et 650 nm.

Selon un mode de réalisation, le coefficient d'extinction de chaque plot de germination 24 est inférieur ou égal à 3 pour une longueur d'onde comprise entre 380 nm et 650 nm.

A titre d'exemple, le matériau composant chaque plot de germination 24 peut correspondre aux exemples indiqués précédemment.

La couche conductrice 156 peut être réalisée en aluminium, en argent ou tout autre matériau conducteur. A titre d'exemple, elle a une épaisseur comprise entre 30 nm et 2000 nm. La couche conductrice 156 peut être déposée par ECD. La couche miroir 154 et la couche conductrice 156 peuvent être confondues.

La figure 12C représente la structure obtenue après une étape de gravure de la couche conductrice 156 et de la couche miroir 154 pour délimiter un plot 158, comprenant une portion 160 de la couche miroir 154 et une portion 162 de la couche conductrice 156, connecté à la couche d'électrode 36 et un plot 164, comprenant une portion 166 de la couche miroir 154 et une portion 168 de la couche conductrice 156, connecté aux plots de germination 24.

La figure 12D représente la structure obtenue après les étapes suivantes :
- dépôt d'une couche isolante 170 s'étendant sur les plots 158, 164 et entre les plots 158, 164 ;
- gravure, dans la couche isolante 170, d'une ouverture 172 exposant le plot conducteur 158 et d'une ouverture 174 exposant le plot conducteur 164 ; et
- dépôt d'une couche conductrice 176 recouvrant la couche isolante 170 et pénétrant dans les ouvertures 172, 174.

La couche isolante 170 peut être réalisée en dioxyde de silicium déposé par PECVD à basse température ou un matériau organique type BCB, Epoxy de quelques microns d'épaisseur typiquement 3-5 µm.

La couche conductrice 176 peut être réalisée en TiCu ou TiAl. A titre d'exemple, elle a une épaisseur comprise entre 500 nm et 2 µm.

La figure 12E représente la structure obtenue après une étape de gravure de la couche conductrice 176 pour délimiter un plot conducteur 178 connecté au plot conducteur 158, une deuxième électrode 180 connectée au plot conducteur 164 et une portion conductrice 182 au contact de la couche isolante 170. La portion conductrice 182 peut jouer le rôle d'un radiateur. La couche isolante 170 peut notamment permettre d'isoler électriquement le puits thermique 182 du plot de contact électrique 158 et/ou de la couche conductrice 156.

Le mode de réalisation décrit en relation avec les figures 12A à 12E présente l'avantage de supprimer la résistance série due au substrat 10.

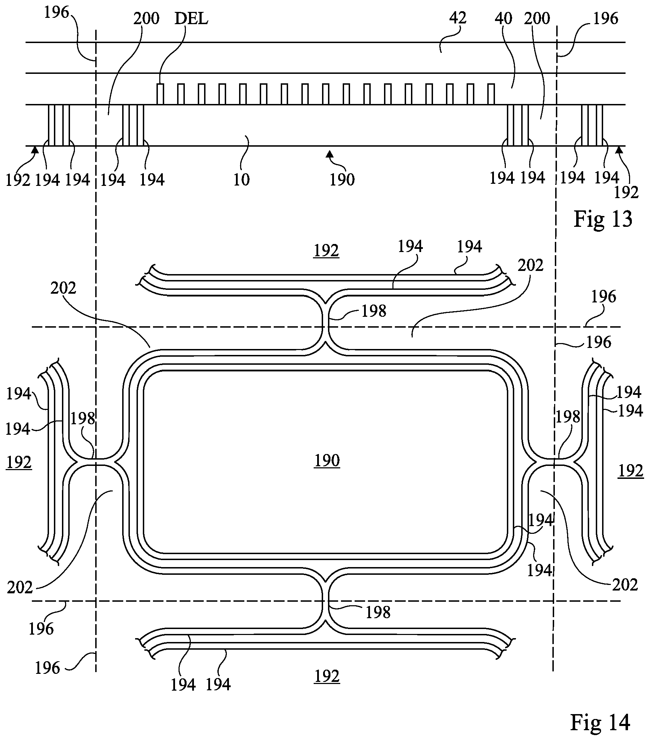

Les figures 13 et 14 sont respectivement une coupe et une vue de dessus, partielles et schématiques, d'un mode de réalisation d'un dispositif optoélectronique 190 à fils formé sur une plaque 10 d'un substrat après l'étape d'amincissement du substrat 10 et avant la découpe du substrat 10. En figure 13, on a, en outre, représenté de façon partielle, des dispositifs optoélectroniques 192 adjacents au dispositif optoélectronique 190.

Chaque dispositif optoélectronique 190, 192 est entouré d'une ou de plusieurs tranchées 194 (deux dans notre exemple) remplies d'un matériau isolant qui s'étendent sur toute l'épaisseur du substrat 10 aminci. A titre d'exemple, chaque tranchée a une largeur supérieure à 1 µm, par exemple d'environ 2 µm. La distance entre les deux tranchées 194 est supérieure à 5 µm, par exemple d'environ 6 µm. Les lignes de découpe du substrat 10, représentées par des lignes à traits courts 196, sont réalisées entre les tranchées 194 du dispositif optoélectronique 190 et les tranchées 194 des dispositifs optoélectroniques 192 adjacents. Les tranchées 194 permettent d'obtenir une isolation électrique latérale du substrat de silicium et donc du dispositif optoélectronique 190 après découpe.

Comme cela apparaît en figure 14, des tranchées supplémentaires 198 relient les tranchées 194 externes de deux dispositifs optoélectroniques adjacents 190, 192. Après découpe, une portion 200 de substrat 10 subsiste à la périphérie de chaque dispositif optoélectronique 190, 192. Les tranchées 198 permettent de diviser cette portion 200 périphérique en plusieurs segments isolés 202. Ceci permet de réduire les risques de court-circuit dans le cas où des plots conducteurs viendraient au contact de ces segments.

Selon un mode de réalisation, le dispositif optoélectronique comprend, en outre, des luminophores adaptés, lorsqu'ils sont excités par la lumière émise par les diodes électroluminescentes, à émettre de la lumière à une longueur d'onde différente de la longueur d'onde de la lumière émise par les diodes électroluminescentes. A titre d'exemple, les diodes électroluminescentes sont adaptées à émettre de la lumière bleue et les luminophores sont adaptés à émettre de la lumière jaune lorsqu'ils sont excités par la lumière bleue. De ce fait, un observateur perçoit une lumière correspondant à une composition des lumières bleue et jaune et qui, selon la proportion de chaque lumière, peut être sensiblement blanche. La couleur finale perçue par l'observateur est caractérisée par ses coordonnées chromatiques telles que définies par les normes de la Commission Internationale de l'Eclairage.

Selon un mode de réalisation, une couche de luminophores est prévue au sein de la couche d'encapsulation 40. De préférence, le diamètre moyen des luminophores est choisi pour qu'au moins une partie des luminophores se répartisse entre les fils 26 lors de l'étape de formation de la couche d'encapsulation 40. De préférence, le diamètre des luminophores est compris entre 45 nm et 500 nm. La concentration en luminophores et l'épaisseur de la couche de luminophores est alors ajustée en fonction des coordonnées chromatiques visées.

Le rapport d'extraction d'un dispositif optoélectronique est égal au rapport entre la quantité de photons qui s'échappent du dispositif optoélectronique et la quantité de photons émis par les diodes électroluminescentes. Chaque diode électroluminescente émet de la lumière dans toutes les directions, et notamment en direction des diodes électroluminescentes voisines. La couche active d'une diode électroluminescente tend à capturer les photons ayant une longueur d'onde inférieure ou égale à la longueur d'onde d'émission. De ce fait, une partie de la lumière émise par une diode électroluminescente est généralement capturée par les couches actives des diodes électroluminescentes voisines. Un avantage de disposer des luminophores entre les fils 26 est que les luminophores convertissent une partie de la lumière, par exemple de couleur bleue, émise par une diode électroluminescente en une lumière à une longueur d'onde plus élevée, par exemple le jaune, avant que la lumière bleue n'atteigne les diodes électroluminescentes voisines. La lumière jaune n'étant pas absorbée par les couches actives des diodes électroluminescentes voisines, le rapport d'extraction du dispositif optoélectronique est augmenté.

Un autre avantage est que les luminophores étant situés à proximité du substrat 10, l'évacuation par le substrat de la chaleur produite lors de l'échauffement des luminophores en fonctionnement est améliorée.

Un autre avantage est que les luminophores n'étant pas disposés dans une couche distincte, l'épaisseur totale du dispositif optoélectronique est réduite.

Un autre avantage est que l'homogénéité de la lumière émise par le dispositif optoélectronique est améliorée. En effet, la lumière qui s'échappe de la couche d'encapsulation 40 dans toutes les directions correspond à une composition de la lumière émise par les diodes électroluminescentes et de la lumière émise par les luminophores.

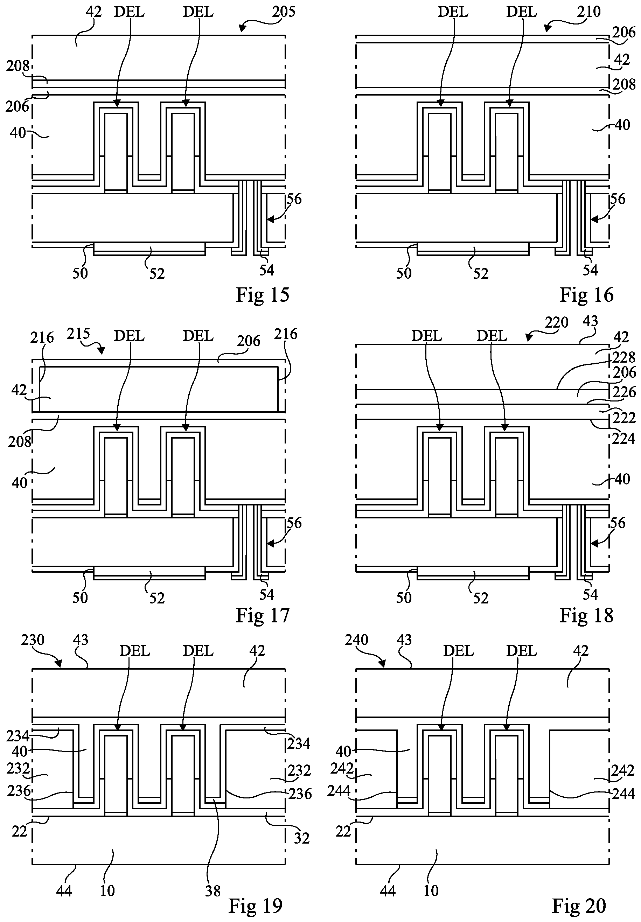

La figure 15 représente un mode de réalisation d'un dispositif optoélectronique 205 comprenant l'ensemble des éléments représentés en figure 2F et comprenant, en outre, entre la couche d'encapsulation 40 et la poignée 42, une couche de luminophores 206 s'étendant sur la couche d'encapsulation 40 et éventuellement une couche de colle 208 s'étendant sur la couche de luminophores 206, la poignée 42 s'étendant sur la couche de colle 208. L'épaisseur de la couche de luminophores 206 peut être comprise entre 50 µm et 100 µm. La couche de luminophores 206 peut correspondre à une couche de silicone ou d'un polymère époxyde dans laquelle sont noyés les luminophores. La couche de luminophores 206 peut être déposée par un procédé de dépôt à la tournette, par un procédé d'impression par jet, par un procédé de sérigraphie ou par un procédé de dépôt de feuille. La concentration en luminophores et l'épaisseur de la couche de luminophores 206 sont ajustées en fonction des coordonnées chromatiques visées. Par rapport au mode de réalisation dans lequel les luminophores sont présents dans la couche d'encapsulation 40, des luminophores de diamètre plus important peuvent être utilisés. En outre, la répartition des luminophores dans la couche de luminophores 206 et l'épaisseur de la couche de luminophores 206 peuvent être contrôlées plus facilement.

La figure 16 représente un mode de réalisation d'un dispositif optoélectronique 210 comprenant l'ensemble des éléments du dispositif optoélectronique 205 représenté en figure 15 à la différence que la couche de luminophores 206 recouvre la poignée 42. Une couche de protection, non représentée, peut recouvrir la couche de luminophores 206. Dans le présent mode de réalisation, la couche de luminophores 206 est, de façon avantageuse, formée dans les dernières étapes du procédé de fabrication du dispositif optoélectronique. Les propriétés colorimétriques du dispositif optoélectronique peuvent donc encore être modifiées pendant la majeure partie du procédé de fabrication du dispositif optoélectronique. En outre, les propriétés colorimétriques du dispositif optoélectronique peuvent facilement être corrigées en fin de procédé si nécessaire en modifiant la couche de luminophores, par exemple en ajoutant une couche de luminophores supplémentaires.

La figure 17 représente un mode de réalisation d'un dispositif optoélectronique 215 comprenant l'ensemble des éléments du dispositif optoélectronique 210 représenté en figure 16 et comprenant, en outre, des tranchées 216 s'étendant dans la poignée 42 et remplies par la couche de luminophores 206. De préférence, les tranchées 216 s'étendent sur la totalité de l'épaisseur de la poignée 42. La distance entre les parois latérales de chaque tranchée 216 est, de préférence, sensiblement égale à l'épaisseur de la couche de luminophores 206 recouvrant la poignée 42.

Pour le dispositif optoélectronique 210, représenté en figure 16, une partie de la lumière émise par les diodes électroluminescentes DEL peut s'échapper par les bords latéraux de la poignée 42 sans avoir traversé la couche de luminophores 206. La couleur de cette lumière s'échappant latéralement est donc différente de la couleur de la lumière ayant traversé la couche de luminophores 206, ce qui peut ne pas être souhaitable si une lumière de couleur homogène est voulue. Pour le dispositif optoélectronique 215, la lumière s'échappant latéralement de la poignée 42 traverse les tranchées 216 remplies de la couche de luminophores 206. La lumière s'échappant de la poignée 42, par la face 43 ou latéralement, a donc avantageusement une couleur homogène.

La figure 18 représente un mode de réalisation d'un dispositif optoélectronique 220 comprenant l'ensemble des éléments du dispositif optoélectronique 205 représenté en figure 15 à la différence que la couche de colle 208 n'est pas représentée et qu'une couche intermédiaire 222 est interposée entre la couche d'encapsulation 40 et la couche de luminophores 206.

La couche intermédiaire 222 est adaptée à laisser passer les rayons lumineux émis par les diodes électroluminescentes DEL à une première longueur d'onde ou dans une première plage de longueur d'onde et à réfléchir les rayons lumineux émis par les luminophores à une deuxième longueur d'onde ou dans une deuxième plage de longueur d'onde. Le rapport d'extraction du dispositif optoélectronique 220 est alors avantageusement augmenté. A titre d'exemple, la couche intermédiaire 222 peut correspondre à un miroir dichroïque qui est un miroir qui réfléchit les rayons lumineux dont la longueur d'onde se situe dans une certaine plage et se laisse traverser par les rayons lumineux dont la longueur d'onde n'appartient pas à cette plage. Un miroir dichroïque peut être formé d'un empilement de couches diélectriques d'indices optiques différents.

Selon un autre exemple, la couche intermédiaire 222 peut être une monocouche réalisée en un matériau ayant un indice de réfraction strictement inférieur à l'indice de réfraction de la couche d'encapsulation 40 et strictement inférieur à l'indice de réfraction de la couche de luminophores. La couche intermédiaire 222 peut correspondre à une couche de silicone ou de polymère époxyde. De plus, un traitement de surface, appelé texturation, est appliqué à la face 224 de la couche d'encapsulation 40 avant la formation de la couche intermédiaire 222 de façon à former des reliefs sur la face 224. L'interface 226 entre la couche intermédiaire 222 et la couche de luminophores 206 est sensiblement plane.

Les rayons lumineux émis par les diodes électroluminescentes DEL traversent l'interface 224 qui est irrégulière même si l'indice de réfraction de la couche intermédiaire 222 est inférieur à l'indice de réfraction de la couche d'encapsulation 40 tandis que les rayons lumineux émis par les luminophores se réfléchissent en majorité sur l'interface 226 étant donné que cette interface 226 est plane et que l'indice de réfraction de la couche intermédiaire 222 est inférieur à l'indice de réfraction de la couche de luminophores 206.

Un procédé de texturation entraînant la formation des reliefs en surface peut être appliqué à la face libre 43 de la poignée 42 et/ou à la face 228 de la couche de luminophores 206 en contact avec la poignée 42.

Pour une couche constituée d'un matériau inorganique, le procédé de texturation d'une surface de la couche peut comprendre une étape de gravure chimique ou une étape d'abrasion mécanique, éventuellement en présence d'un masque protégeant des parties de la surface traitée pour favoriser la formation de motifs en surface. Pour une couche constituée d'un matériau organique, le procédé de texturation d'une surface de la couche peut comprendre une étape d'estampage, de moulage, etc.

Pour les dispositifs optoélectroniques décrits précédemment, une partie de la lumière émise par les diodes électroluminescentes DEL peut s'échapper par les bords latéraux de la couche d'encapsulation 40. Ceci n'est généralement pas souhaitable dans la mesure où cette lumière n'est pas perçue par un observateur dans des conditions normales de fonctionnement du dispositif optoélectronique. Selon un mode de réalisation, le dispositif optoélectronique comprend, en outre, des moyens adaptés à réfléchir les rayons lumineux s'échappant latéralement du dispositif optoélectronique pour augmenter la quantité de lumière s'échappant par la face 43 de la poignée 42.

La figure 19 représente un mode de réalisation d'un dispositif optoélectronique 230 comprenant l'ensemble des éléments du dispositif optoélectronique représenté en figure 2F et comprenant, en outre, des blocs 232 disposés sur la couche isolante 32 et entourant au moins partiellement l'ensemble de diodes électroluminescentes DEL. Chaque bloc 232 est recouvert d'une couche métallique 234, correspondant, par exemple, à un prolongement de la couche conductrice 38. A titre d'exemple, les blocs 232 peuvent correspondre à des blocs de résine photosensible formés sur la couche isolante 32 avant le dépôt de la couche d'encapsulation 40. De préférence, la hauteur des blocs 232 est inférieure à la hauteur maximale de la couche d'encapsulation 40. En figure 19, les flancs latéraux 236 des blocs 232 sont sensiblement perpendiculaires à la face 22 du substrat 10. A titre de variante, les flancs latéraux 236 peuvent être inclinés par rapport à la face 22 de façon à favoriser la réflexion des rayons lumineux vers la face 43 de la poignée 42.

La figure 20 représente un mode de réalisation d'un dispositif optoélectronique 240 comprenant l'ensemble des éléments du dispositif optoélectronique représenté en figure 2F et comprenant, en outre, des blocs 242 disposés sur la couche isolante 32 et entourant au moins partiellement l'ensemble de diodes électroluminescentes DEL. Les blocs 242 sont constitués d'un matériau réfléchissant. Il peut s'agir de silicone chargé de particules réfléchissantes, par exemple de particules d'oxyde de titane (TiO₂). A titre d'exemple, les blocs 242 peuvent être formés sur la couche isolante 32 par un procédé de sérigraphie avant le dépôt de la couche d'encapsulation 40. De préférence, la hauteur des blocs 242 est inférieure à la hauteur maximale de la couche d'encapsulation 40. En figure 20, les flancs latéraux 244 des blocs 242 sont sensiblement perpendiculaires à la face 22 du substrat 10. A titre de variante, les flancs latéraux 244 peuvent être inclinés par rapport à la face 22 de façon à favoriser la réflexion des rayons lumineux vers la face 43 de la poignée 42.

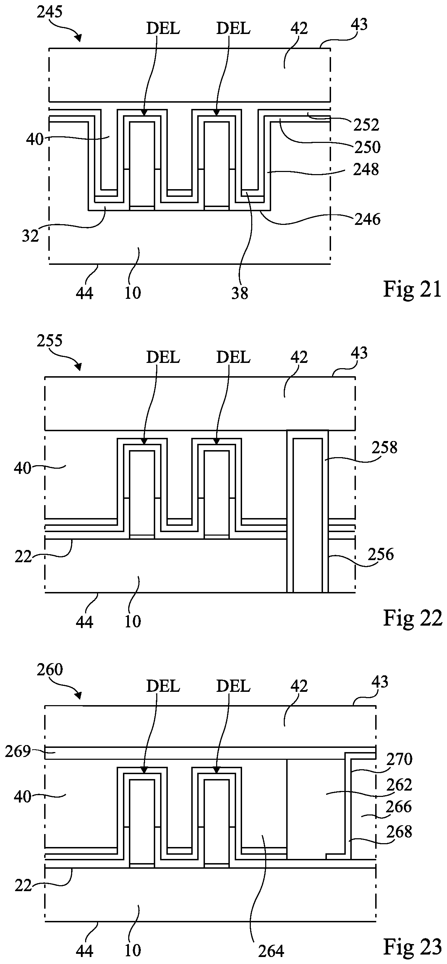

La figure 21 représente un mode de réalisation d'un dispositif optoélectronique 245 comprenant l'ensemble des éléments du dispositif optoélectronique représenté en figure 2F à la différence que les diodes électroluminescentes DEL sont réalisées dans une cavité 246 formées dans le substrat 10. Les flancs latéraux 248 de la cavité 246 sont recouverts d'une couche isolante 250, correspondant par exemple à un prolongement de la couche isolante 32 et d'une couche métallique 252, correspondant par exemple à un prolongement de la couche conductrice 38. De préférence, la profondeur de la cavité 246 est inférieure à la hauteur maximale de la couche d'encapsulation 40. En figure 21, les flancs latéraux 248 de la cavité sont sensiblement perpendiculaires à la face 43 de la poignée 42. A titre de variante, les flancs latéraux 248 peuvent être inclinés par rapport à la face 43 de façon à favoriser la réflexion des rayons lumineux vers la face 43 de la poignée 42.

La figure 22 représente un mode de réalisation d'un dispositif optoélectronique 255 comprenant l'ensemble des éléments du dispositif optoélectronique représenté en figure 2F et comprenant, en outre, des tranchées 256 entourant les diodes électroluminescentes DEL, une seule tranchée étant représentée en figure 22. Les tranchées 256 traversent le substrat 10 et la couche d'encapsulation 40. Les parois internes de chaque tranchée 256 sont recouvertes d'une couche réfléchissante 258, par exemple une couche métallique, par exemple en argent ou aluminium ou une couche de vernis, ayant une épaisseur comprise entre 30 nm et 2000 nm. Une couche isolante, non représentée, peut être prévue pour isoler la couche réfléchissante 258 du substrat 10. Les tranchées 256 peuvent être réalisées après l'étape d'amincissement du substrat 10 décrite précédemment en relation avec la figure 2D. Un avantage par rapport aux dispositifs optoélectroniques 230, 240 et 245 est que la couche d'encapsulation 40 peut être formée sur une surface plane, ce qui en facilite le dépôt.

La figure 23 représente un mode de réalisation d'un dispositif optoélectronique 260 comprenant l'ensemble des éléments du dispositif optoélectronique représenté en figure 2F et comprenant, en outre, des tranchées 262 réalisées dans la couche d'encapsulation 40 et entourant les diodes électroluminescentes DEL, une seule tranchée étant représentée en figure 23. Les tranchées 262 peuvent être remplies d'air. Les tranchées 262 peuvent être réalisées par gravure après l'étape de formation de la couche d'encapsulation 40 dans le cas où la couche d'encapsulation 40 est en un matériau inorganique. Les tranchées 262 délimitent, dans la couche d'encapsulation 40, un bloc central 264 dans lequel sont noyées les diodes électroluminescentes et des blocs 266 périphériques entourant au moins partiellement le bloc central 264. Chaque bloc périphérique 266 est recouvert d'une couche métallique 268, par exemple en argent ou aluminium et ayant une épaisseur comprise entre 30 nm et 2000 nm. Une couche de colle 269 peut être prévue entre la poignée 42 et les blocs 264, 266. En figure 23, les flancs latéraux 270 des blocs périphériques 266 sont sensiblement perpendiculaires à la face 22 du substrat 10. A titre de variante, les flancs latéraux 270 peuvent être inclinés par rapport à la face 22 de façon à favoriser la réflexion des rayons lumineux vers la face 43 de la poignée 42. Un avantage par rapport aux dispositifs optoélectroniques 230, 240 et 245 est que la couche d'encapsulation 40 peut être formée sur une surface plane ce qui en facilite le dépôt.

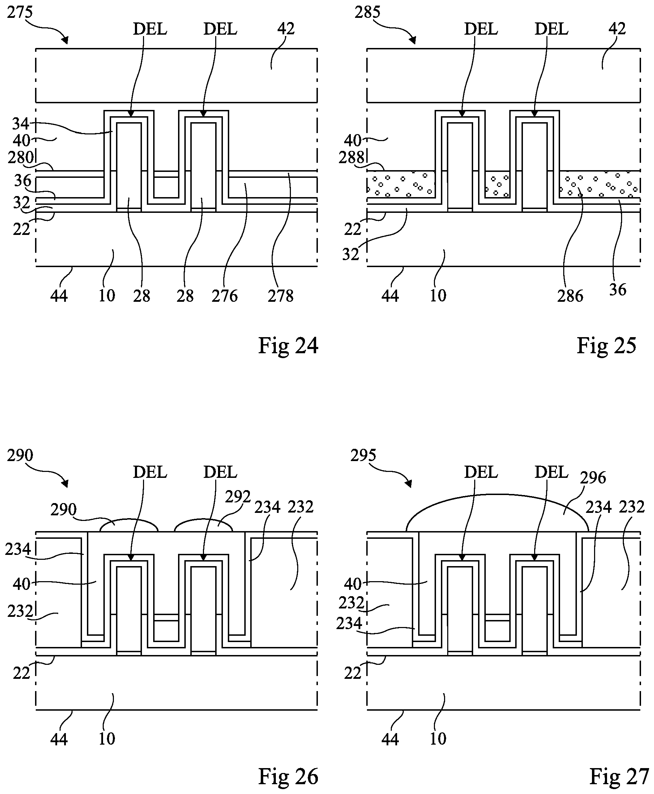

La figure 24 représente un mode de réalisation d'un dispositif optoélectronique 275 comprenant l'ensemble des éléments du dispositif optoélectronique représenté en figure 2F et comprenant, en outre, une couche isolante 276 s'étendant sur la couche d'électrode 32 entre les diodes électroluminescentes DEL mais ne recouvrant pas les diodes électroluminescentes DEL. La couche isolante 276 est recouverte d'une couche réfléchissante 278. La couche réfléchissante 278 correspond, de préférence, à une couche métallique, par exemple en aluminium, en un alliage à base d'aluminium, notamment AlSi_{z}, AlₓCu_{y} (par exemple avec x égal à 1 et y égal à 0,8 %), en argent, en or, en nickel, ou en palladium. A titre d'exemple, la couche réfléchissante 278 a une épaisseur comprise entre 30 nm et 2000 nm. La couche réfléchissante 278 peut comprendre un empilement de plusieurs couches comprenant notamment une couche d'accroche, par exemple en titane. Les épaisseurs de la couche isolante 276 et de la couche réfléchissante 278 sont choisies pour que la face 280 de la couche réfléchissante en contact avec la couche d'encapsulation 40 soit à proximité de l'extrémité de la coque 34, par exemple à moins de 1 µm de l'extrémité de la coque 34. Par rapport aux modes de réalisation décrits précédemment, la surface réfléchissante 280 permet avantageusement d'éviter que des rayons lumineux émis par la coque 34 d'une diode électroluminescente DEL vers l'extérieur de la diode électroluminescente ne pénètrent dans la portion inférieure 28 de la diode électroluminescente ou les portions inférieures 28 des diodes électroluminescentes voisines. Le rapport d'extraction est ainsi augmenté.

La figure 25 représente un mode de réalisation d'un dispositif optoélectronique 285 comprenant l'ensemble des éléments du dispositif optoélectronique 275 représenté en figure 24 à la différence que la couche isolante 276 et la couche réfléchissante 280 sont remplacées par une couche réfléchissante 286 s'étendant sur la couche d'électrode 32 entre les diodes électroluminescentes DEL mais ne recouvrant pas les diodes électroluminescentes DEL. Il peut s'agir d'une couche de silicone chargée de particules réfléchissantes, par exemple des particules de TiO₂, ou d'une couche de TiO₂. L'épaisseur de la couche réfléchissante 286 est choisie pour que la face 288 de la couche réfléchissante 286 en contact avec la couche d'encapsulation 40 soit à proximité de l'extrémité de la coque 34, par exemple à moins de 1 µm de l'extrémité de la coque 34. Le rapport d'extraction est ainsi augmenté.

Selon un mode de réalisation, une ou plusieurs lentilles sont prévues sur la face 43 de la poignée 42. Les lentilles permettent d'accroître la focalisation des rayons lumineux s'échappant depuis la face 43 selon la direction perpendiculaire à la face 43 et donc d'augmenter la quantité de rayons lumineux perçus par un utilisateur regardant la face 43.

La figure 26 représente un mode de réalisation d'un dispositif optoélectronique 290 comprenant l'ensemble des éléments du dispositif optoélectronique 230 représenté en figure 19 à la différence que la poignée 42 n'est pas présente. En outre, le dispositif optoélectronique 290 comprend, pour chaque diode électroluminescente DEL, une lentille convergente 292 disposée sur la couche d'encapsulation 40.

La figure 27 est une vue analogue à la figure 26 d'un mode de réalisation 295 dans lequel une lentille 296 est associée à plusieurs diodes électroluminescentes DEL.

Des modes de réalisation particuliers de la présente invention ont été décrits. Diverses variantes et modifications apparaîtront à l'homme de l'art. De plus, bien que, dans les modes de réalisation décrits précédemment, chaque fil 26 comprenne une portion passivée 28, à la base du fil en contact avec l'un des plots de germination 24, cette portion passivée 28 peut ne pas être présente.

En outre, bien que des modes de réalisation aient été décrits pour un dispositif optoélectronique pour lequel la coque 34 recouvre le sommet du fil 26 associé et une partie des flancs latéraux du fil 26, la coque peut n'être prévue qu'au sommet du fil 26.

## Revendications

1. Procédé de fabrication de dispositifs optoélectroniques (14) comprenant les étapes successives suivantes :
(a) prévoir un substrat (10) comportant une première face (22) ;
(b) former, sur la première face, des ensembles de diodes électroluminescentes (DEL) comprenant des éléments semiconducteurs filaires, coniques ou tronconiques ;
(c) former, pour chaque ensemble de diodes électroluminescentes, une couche d'électrode (36) recouvrant chaque diode électroluminescente dudit ensemble et une couche conductrice (38) recouvrant la couche d'électrode autour des diodes électroluminescentes dudit ensemble ;
(d) recouvrir la totalité de la première face d'une couche (40) encapsulant les diodes électroluminescentes ;
(e) réduire l'épaisseur du substrat, le substrat comprenant, après l'étape (e), une deuxième face (44) opposée à la première face (22) ;
(f) former un élément conducteur (56) isolé électriquement du substrat et traversant le substrat depuis la deuxième face jusqu'à au moins la première face (22), l'élément conducteur étant en contact avec la couche conductrice (38) ;
(g) former, sur la deuxième face, au moins un premier plot conducteur (52 ; 60 ; 82 ; 102 ; 132) en contact avec le substrat ; et
(h) découper la structure obtenue pour séparer chaque ensemble de diodes électroluminescentes.

2. Procédé selon la revendication 1, comprenant, à l'étape (f), la formation, sur la deuxième face (44), au moins d'un deuxième plot conducteur (72 ; 90 ; 134) en contact avec l'élément conducteur (56).

3. Procédé selon la revendication 1 ou 2, comprenant la formation d'au moins un élément conducteur (106, 110) supplémentaire, isolé électriquement du substrat et traversant le substrat depuis la deuxième face jusqu'à au moins la première face (22), et en contact avec la base d'au moins l'une des diodes électroluminescentes (DEL).

4. Procédé selon la revendication 1, dans lequel la formation de l'élément conducteur (56) comprend successivement, après l'étape (e), la gravure d'une ouverture (46) dans le substrat (10) depuis la deuxième face (44), la formation d'une couche isolante (48) au moins sur les parois latérales de l'ouverture, et la formation d'une couche conductrice (54) recouvrant la couche isolante, ou le remplissage de l'ouverture par un matériau conducteur.

5. Procédé selon la revendication 1, dans lequel l'étape (f) est au moins réalisée en partie avant l'étape (b) et comprend, avant l'étape (b), la gravure d'une ouverture (92) dans le substrat depuis la première face (22) sur une partie de l'épaisseur du substrat, l'ouverture étant ouverte sur la deuxième face (44) à l'étape (e).

6. Procédé selon la revendication 5, dans lequel la couche d'électrode (36) et la couche conductrice (38) sont, en outre, formées dans l'ouverture (92).

7. Procédé selon la revendication 5, comprenant, avant l'étape (b), la formation d'une portion isolante (122) au moins sur les parois latérales de l'ouverture (92) et le remplissage de l'ouverture par un matériau conducteur.

8. Procédé selon l'une quelconque des revendications 1 à 7, comprenant, avant l'étape (e), une étape de fixation d'un support (42) à la couche (40) encapsulant les diodes électroluminescentes (DEL).

9. Procédé selon l'une quelconque des revendications 1 à 8, dans lequel la couche (40) encapsulant les diodes électroluminescentes (DEL) comprend des luminophores entre les diodes électroluminescentes.

10. Procédé selon la revendication 8, comprenant une étape de formation d'une couche de luminophores (206) recouvrant la couche (40) encapsulant les diodes électroluminescentes (DEL) ou recouvrant le support (42).

11. Procédé selon la revendication 10, comprenant une étape de formation d'une couche (222), entre la couche (40) encapsulant les diodes électroluminescentes (DEL) et la couche de luminophores (206), adaptée à transmettre les rayons lumineux émis par les diodes électroluminescentes et à réfléchir les rayons lumineux émis par les luminophores.

12. Procédé selon l'une quelconque des revendications 1 à 11, comprenant une étape de formation de réflecteurs (232 ; 242) autour des diodes électroluminescentes (DEL) entre le substrat (10) et la couche (40) encapsulant les diodes électroluminescentes (DEL) et dont la hauteur est supérieure à 50 % de la hauteur des diodes électroluminescentes.

## Patentansprüche

1. Ein Verfahren zur Herstellung elektronischer Vorrichtungen (14), welches die aufeinanderfolgenden Schritte aufweist:
(a) Vorsehen eines Substrats (10) mit einer ersten Oberfläche (22);
(b) Formen auf der ersten Oberfläche Anordnungen von Licht emittierenden Dioden (DEL), die konisch oder sich verjüngende drahtförmige Halbleiterelemente aufweisen;
(c) Formen für jede Anordnung von Licht emittierenden Dioden eine Elektrodenschicht (36), die jede Licht emittierende Diode der erwähnten Anordnung abdeckt und eine leitende Schicht (38), die die Elektrodenschicht um die Licht emittierenden Dioden der erwähnten Anordnung herum abdeckt;
(d) Abdecken der gesamten ersten Oberfläche einer Schicht (40), die die Licht emittierenden Dioden einkapselt;
(e) Verkleinern der Substratdicke, wobei das Substrat nach dem Schritt (e) eine zweite Oberfläche (44) entgegengesetzt zur ersten Oberfläche (22) besitzt;
(f) Formen eines leitenden Elementes (56) elektrisch isoliert von dem Substrat und das Substrat von der zweiten Oberfläche den ganzen Weg zumindest der ersten Oberfläche (22) zu kreuzen, wobei das leitende Element in Kontakt mit der leitenden Schicht (38) steht;
(g) Formen auf der zweiten Oberfläche mindestens eines ersten leitenden Anschlusses (52; 60; 82; 102; 132), und zwar in Kontakt mit dem Substrat; und
(h) Zerschneiden der erhaltenen Struktur zur Trennung jeder Anordnung der Licht emittierenden Dioden.

2. Das Verfahren nach Anspruch 1, welches folgendes aufweist: Am Schritt (f) Formen auf der erwähnten zweiten Oberfläche (44) mindestens eines zweiten leitenden Anschlusses (72; 90; 134), und zwar in Kontakt mit dem leitenden Element (56).

3. Das Verfahren nach Anspruch 1 oder 2, welches für die Formung mindestens ein zusätzliches leitendes Element (106, 110) aufweist, und zwar elektrisch isoliert von dem Substrat und das Substrat kreuzend von der zweiten Oberfläche den ganzen Weg zu mindestens der ersten Oberfläche (22) und in Kontakt mit der Basis der mindestens einen der Licht emittierenden Dioden (DEL).

4. Das Verfahren nach Anspruch 1, wobei das Formen des leitenden Elements (56) aufeinanderfolgend folgendes aufweist, nach dem Schritt (e), Ätzen einer Öffnung (46) in dem Substrat (10) von der zweiten Oberfläche (44), Formen einer Isolierschicht (48), mindestens auf den seitlichen Wänden der Öffnung und Formen einer leitenden Schicht (54), welche die Isolierschicht abdeckt oder aber Füllen der Öffnung mit leitfähigem Material.

5. Das Verfahren nach Anspruch 1, wobei der Schritt (f) mindestens teilweise vor dem Schritt (b) ausgeführt wird und folgendes aufweist: Vor dem Schritt (b) Ätzen einer Öffnung (92) in das Substrat von der ersten Oberfläche (22) über einen Teil der Substratdicke, wobei die Öffnung geöffnet ist auf der zweiten Oberfläche (44) im Schritt (e).

6. Das Verfahren nach Anspruch 5, wobei die Elektrodenschicht (36) und die leitende Schicht (38) ferner in der Öffnung (92) geformt sind.

7. Das Verfahren nach Anspruch 5, welches folgendes aufweist: Vor dem Schritt (b), das Formen eines Isolationsteils (122) an mindestens den seitlichen Wänden der Öffnung (92) und Füllen der Öffnung mit einem leitenden Material.

8. Das Verfahren nach einem der Ansprüche 1 bis 7, wobei folgendes vorgesehen ist: Vor dem Schritt (e) ein Schritt des Anbringens eines Trägers (42) an der Schicht (40), und zwar die Licht emittierenden Dioden (DEL) einkapselnd.

9. Das Verfahren nach einem der Ansprüche 1 bis 8, wobei die Schicht (40), welche die Licht emittierenden Dioden (DEL) einkapselt, folgendes aufweist: Phosphore zwischen den Licht emittierenden Dioden.

10. Das Verfahren nach Anspruch 8, wobei folgendes vorgesehen ist: Ein Schritt des Formens einer Schicht aus Phosphoren (206), und zwar die Schicht (40) abdeckend, die Licht emittierenden Dioden (DEL) einkapselnd oder den Träger (42) einkapselnd.

11. Das Verfahren nach Anspruch 10, wobei folgendes vorgesehen ist: Ein Schritt des Formens einer Schicht (222) zwischen der Schicht (40) die Licht emittierenden Dioden (DEL) und die Phosphorschicht (206) einkapselnd und ferner in der Lage zur Übertragung der Lichtstrahlen emittiert durch die Licht emittierenden Dioden und zur Reflexion der Lichtstrahlen emittiert durch die Phosphore.

12. Das Verfahren nach einem der Ansprüche 1 bis 11, welches folgendes aufweist: Einen Schritt des Formens von Reflektoren (232; 242) um die Licht emittierenden Dioden (DEL) herum zwischen dem Substrat (10) und der Schicht (40) die Licht emittierenden Dioden (DEL) einkapselnd und mit einer Höhe größer um 50 % als die Höhe der Licht emittierenden Dioden.

## Claims

1. A method of manufacturing optoelectronic devices (14) comprising the successive steps of:
(a) providing a substrate (10) having a first surface (22) ;
(b) forming, on the first surface, assemblies of light-emitting diodes (DEL) comprising, conical or tapered wire-shaped semiconductor elements;
(c) forming, for each assembly of light-emitting diodes, an electrode layer (36) covering each light-emitting diode of said assembly and a conductive layer (38) covering the electrode layer around the light-emitting diodes of said assembly;
(d) covering the entire first surface of a layer (40) encapsulating the light-emitting diodes;
(e) decreasing the substrate thickness, the substrate having, after step (e), a second surface (44) opposite to the first surface (22);
(f) forming a conductive element (56) electrically insulated from the substrate and crossing the substrate from the second surface all the way to at least the first surface (22), the conductive element being in contact with the conductive layer (38) ;
(g) forming, on the second surface, at least one first conductive pad (52; 60; 82; 102; 132) in contact with the substrate; and
(h) cutting the obtained structure to separate each assembly of light-emitting diodes.

2. The method of claim 1, comprising, at step (f), forming, on the second surface (44), at least one second conductive pad (72; 90; 134) in contact with the conductive element (56).

3. The method of claim 1 or 2, comprising forming at least one additional conductive element (106, 110), electrically insulated from the substrate and crossing the substrate from the second surface all the way to at least the first surface (22), and in contact with the base of at least one of the light-emitting diodes (DEL).

4. The method of claim 1, wherein the forming of the conductive element (56) successively comprises, after step (e), etching an opening (46) in the substrate (10) from the second surface (44), forming an insulating layer (48) at least on the lateral walls of the opening, and forming a conductive layer (54) covering the insulating layer, or filling the opening with a conductive material.

5. The method of claim 1, wherein step (f) is at least partly carried out before step (b) and comprises, before step (b), etching an opening (92) in the substrate from the first surface (22) across a portion of the substrate thickness, the opening being opened on the second surface (44) at step (e).

6. The method of claim 5, wherein the electrode layer (36) and the conductive layer (38) are further formed in the opening (92).

7. The method of claim 5, comprising, before step (b), forming an insulating portion (122) at least on the lateral walls of the opening (92) and filling the opening with a conductive material.

8. The method of any of claims 1 to 7, comprising, before step (e), a step of attaching a support (42) to the layer (40) encapsulating the light-emitting diodes (DEL).

9. The method of any of claims 1 to 8, wherein the layer (40) encapsulating the light-emitting diodes (DEL) comprises phosphors between the light-emitting diodes.

10. The method of claim 8, comprising a step of forming a layer of phosphors (206) covering the layer (40) encapsulating the light-emitting diodes (DEL) or covering the support (42).

11. The method of claim 10, comprising a step of forming a layer (222), between the layer (40) encapsulating the light-emitting diodes (DEL) and the phosphor layer (206), capable of transmitting the light rays emitted by the light-emitting diodes and of reflecting the light rays emitted by the phosphors.

12. The method of any of claims 1 to 11, comprising a step of forming reflectors (232; 242) around the light-emitting diodes (DEL) between the substrate (10) and the layer (40) encapsulating the light-emitting diodes (DEL) and having a height greater by 50% than the height of the light-emitting diodes.
